# EUROPÄISCHE PATENTSCHRIFT

(11) **EP 2 030 262 B1**
(45) Veröffentlichungstag und Bekanntmachung des Hinweises auf die Patenterteilung: **28.07.2010**
(21) Anmeldenummer: 07729362.9
(22) Anmeldetag: 22.05.2007
(51) Int. Cl.: H01L 41/053, H01L 41/083, F02M 51/06

(54) **ANORDNUNG MIT EINEM BESCHICHTETEN PIEZOAKTOR**
ARRANGEMENT WITH A COATED PIEZO ACTUATOR
DISPOSITIF ÉQUIPÉ D'UN ACTIONNEUR PIÉZOÉLECTRIQUE REVÊTU

(30) Priorität: 06.06.2006 DE 102006026152
(43) Veröffentlichungstag der Anmeldung: 04.03.2009
(73) Patentinhaber: Robert Bosch GmbH, 70442 Stuttgart (DE)
(72) Erfinder: DE PAOLI, Albano, 75417 Muehlacker (DE); SCHUERG, Stefan, 71636 Ludwigsburg (DE); STOECKLEIN, Wolfgang, 70176 Stuttgart (DE); RAPP, Holger, 71254 Ditzingen (DE); PAUER, Thomas, 71691 Freiberg (DE); BOECKING, Friedrich, 70499 Stuttgart (DE); HOLST, Marco, 70597 Stuttgart (Hoffeld) (DE); SOMMARIVA, Helmut, 8053 Graz (AT); LIEBSCHER, Claudia, 96047 Bamberg (DE); CROMME, Peter, 96117 Memmelsdorf/Drosendorf (DE)
(86) Internationale Anmeldenummer: PCT/EP2007/054920
(87) Internationale Veröffentlichungsnummer: WO 2007/141134

(56) Entgegenhaltungen:
- EP-A1- 1 574 702
- WO-A-01/63121
- WO-A-02/061856
- US-A- 5 438 232
- US-A1- 2002 084 872
- US-A1- 2002 123 592

## Beschreibung

Die Erfindung betrifft eine Anordnung mit einem beschichteten Piezoaktor mit mindestens einem Piezoelement, nach den gattungsgemäßen Merkmalen des Hauptanspruchs.

### Stand der Technik

Es ist an sich bekannt, dass zum Aufbau des zuvor erwähnten Piezoaktors ein Piezoelement so eingesetzt werden kann, dass unter Ausnutzung des sogenannten Piezoeffekts eine Steuerung des Nadelhubes eines Ventils oder dergleichen vorgenommen werden kann. Das Piezoelement ist aus einem Material mit einer geeigneten Kristallstruktur so aufgebaut, dass bei Anlage einer äußeren elektrischen Spannung eine mechanische Reaktion des Piezoelements erfolgt, die in Abhängigkeit von der Kristallstruktur und der Anlagebereiche der elektrischen Spannung einen Druck oder Zug in eine vorgebbare Richtung darstellt. Derartige Piezoaktoren eignen sich beispielsweise für Anwendungen, bei denen Hubbewegungen unter hohen Betätigungskräften und hohen Taktfrequenzen ablaufen.

Beispielsweise ist ein solcher Piezoaktor als Bestandteil eines Piezoinjektors aus der DE 10026005 A1 bekannt, der zur Ansteuerung der Düsennadel bei Injektoren zur Einspritzung von Kraftstoff in den Brennraum eines Verbrennungsmotors verwendet werden kann. Bei diesem Piezoaktor ist ein Piezoelement als Stapel mehrerer elektrisch miteinander gekoppelter piezokeramischer Schichten aufgebaut, das über einen Aktorfuß und einen Aktorkopf unter Vorspannung zwischen zwei Anschlägen gehalten ist. Jede piezokeramische Schicht ist als Piezolage zwischen zwei Innenelektroden eingefasst, über die von außen eine elektrische Spannung angelegt werden kann. Aufgrund dieser elektrischen Spannung führen die piezokeramischen Schichten dann jeweils kleine Hubbewegungen in Richtung des Potenzialgefälles aus, die sich zum Gesamthub des Piezoaktors addieren. Dieser Gesamthub ist über die Höhe der angelegten Spannung veränderbar und kann auf ein mechanisches Stellglied übertragen werden.

Solche bekannte Anordnungen werden häufig zur Einbringung von Kraftstoff in direkt einspritzende Dieselmotoren als so genannte Common Rail Systeme eingesetzt. Bei diesen als Common Rail Injektoren bekannten Systemen kann dabei der Einspritzdruck auf einfache Weise an die Last und Drehzahl des Verbrennungsmotors angepasst werden.

Diese Common Rail Injektoren können dabei so aufgebaut werden, dass eine direkt vom Piezoaktor gesteuerte Düsennadel vorhanden ist, wobei der Piezoaktor direkt oder indirekt vom Druck des Kraftstoffs umgeben ist und zwischen der Düsennadel und dem Piezoaktor lediglich ein hydraulischer Kopplungsraum vorgesehen ist. Hierbei ist es wichtig, dass der relativ empfindliche Piezoaktor im inneren Volumen eines Haltekörpers, der mit dem Kraftstoff unter hohem Druck gefüllt ist durch diesen Kraftstoff weder angegriffen noch zerstört wird.

Für sich gesehen sind einige Methoden zur Abdichtung des Piezoaktors, insbesondere wenn sich dieser im Niederdruckbereich eines Piezoinjektors befindet, gegenüber dem umgebenden Medium bekannt. Beispielsweise kann ein solcher Piezoaktor in einer stabilen Metallhülse gekapselt sein, wobei auf der mechanisch aktiven Stirnfläche des Piezoaktors sich der Aktorkopf befindet, welcher den Hub und die Kraft des Piezoaktors nach außen überträgt. Dieser Aktorkopf ist dann über eine Membran mit der stabilen Hülse verbunden. Dadurch schafft die Membran eine flexible und dichte Verbindung zwischen dem Aktorkopf und der Hülse.

Bei einer Anwendung des Piezoaktors im Hochdruckbereich eines Piezoinjektors ist die zuvor beschrieben Lösung jedoch nachteilig hinsichtlich der Festigkeit der Membran und auch hinsichtlich der Festigkeit der Hülse. Aus DE 10217361 A1 ist eine Lösung bekannt, bei der ein einzelner Piezoaktor an Teilen seiner Oberfläche zunächst mit einer organischen Basisschicht beschichtet ist und diese ist dann wiederum mit einer anorganischen Deckschicht versehen, welche die Aufgabe hat, die Basisschicht gegenüber dem umgebenden Kraftstoff abzudichten, der ansonsten die organische Basisschicht angreifen würde.

Ferner ist beispielsweise aus der WO 0261856 A1 bekannt, dass bei einem Piezoaktor zunächst ein Schrumpfschlauch über das Piezoelement und den Aktorfuß und den Aktorkopf gezogen wird. Im Folgenden wird der Zwischenraum zwischen dem Schrumpfschlauch und dem Piezoaktor mit einem Füllmaterial gefüllt und schließlich wird der Schrumpfschlauch durch Wärmeeinwirkung geschrumpft und dadurch der Piezoaktor und das Füllmaterial dicht eingeschlossen.

Diese bekannten Anordnungen sind in der Regel nur sehr aufwendig und kostenintensiv zu realisieren.

Eine gestapelte piezoelektrische Vorrichtung mit einem Beschichtungselement, das elektrisch isolierende Eigenschaften hat und das einen Anstoßabschnitt zwischen Anstoßelementen und der piezoelektrischen Vorrichtung abdeckt, ist in US 2002/0084872 gezeigt.

### Offenbarung der Erfindung

Die Erfindung geht von einer eingangs beschriebenen Anordnung zur Bildung eines Piezoaktors aus, der mindestens ein Piezoelement aufweist, das jeweils aus einem Mehrschichtaufbau von Piezolagen besteht, wobei zwischen den Piezolagen angeordnete Innenelektroden in Richtung des Lagenauf-baus des Piezoelements abwechselnd mit einer unterschiedlichen Polarität einer elektrischen Spannung beaufschlagt sind. Ferner ist ein mindestens die Piezolagen umgebendes Isolationsmedium und es ist ein Aktorkopf und ein Aktorfuß an den Enden des Piezoelements vorhanden. Ein durch diese Anordnung gebildeter Piezoaktor kann vorzugsweise Bestandteil eines eingangs erwähnten Piezoinjektors für ein Einspritzsystem für Kraftstoff bei einem Verbrennungsmotor sein, wobei der Kraftstoff den beschichteten Piezoaktor umströmt.

Erfindungsgemäß ist um das Piezoelement oder die Piezoelemente und zumindest teilweise um den Aktorkopf und den Aktorfuß in vorteilhafter Weise ein mehrlagiges Deckschichtsystem aus mindestens einer Lage eines Isolationsmaterials angeordnet. Eine Lage umschließt dabei auch die Fügestellen zwischen dem oder den Piezoelementen und dem Aktorkopf sowie dem Aktorfuß dichtend. Die Lagen des Deckschichtsystems sind dabei vorzugsweise aus einem Kunststoffmaterial hergestellt.

In vorteilhafter Weise sind bei dem mehrlagigen Deckschichtsystem nur teilweise mehrere Lagen im Verlauf der Oberfläche angeordnet, wobei jedoch an jeder Stelle der Oberfläche des Piezoelements oder der Piezoelemente und zumindest teilweise um den Aktorkopf und den Aktorfuß mindestens eine Lage des Isolationsmaterials vorhanden ist.

Weiterhin ist bei dem mehrlagigen Deckschichtsystem zumindest die Lage direkt auf der Oberfläche des Piezoelements oder der Piezoelemente so gestaltet, dass diese hier nicht haftet, so dass eine Relativbewegung der Lage zur Oberfläche des jeweiligen Piezoelements und/oder der Lagen untereinander ausführbar ist.

Bei einer vorteilhaften Ausführungsform ist der Piezoaktor aus mindestens zwei in Betätigungsrichtung in Reihe liegenden Piezoelementen aufgebaut, die über inaktive Bereiche, d.h. über Bereiche ohne spannungsbeaufschlagte Innenelektroden, aneinander und an den Aktorkopf und den Aktorfuß gefügt sind. Der Aktorkopf und der Aktorfuß sind dabei in der Regel aus einem metallischen oder einem keramischen Material hergestellt.

Beispielsweise kann eine Verbindung zwischen der mindestens einen Lage des Deckschichtsystems und dem oder den Piezoelementen sowie dem Aktorkopf und dem Aktorfuß zumindest teilweise durch Formschluss gebildet werden. Hier kommt aber auch, je nach Anwendungsfall, eine chemische Bindung oder ein Haftvermittler in Frage, der bei einem mehrlagigen Deckschichtsystem auch zwischen den Lagen angeordnet werden kann.

Bei einem mehrlagigen Deckschichtsystem kann die Lage direkt auf der Oberfläche des Piezoelements oder der Piezoelemente und um den Aktorkopf und den Aktorfuß aus einem elastischen Material gebildet, das eine, zum Beispiel durch den Hub des Piezoaktors verursachte Längsdehnung mitmacht. Dies wird durch ein entsprechendes Elastizitätsmodul dieser Lage erreicht, so dass dann mechanische Spannungen auf der äußeren Oberfläche des Deckschichtsystems minimiert sind.

Das Material des Deckschichtsystems kann vorteilhaft so gewählt werden, dass zumindest die Lage auf der Oberfläche des Piezoelements oder der Piezoelemente aus elektrisch isolierendem Material gebildet ist.

Ferner kann auf einfache Weise eine Verbindung zwischen den mehreren Piezoelementen untereinander und/oder zwischen den Piezoelementen und dem Aktorkopf und/oder dem Aktorfuß durch Formschluss, durch Kraftschluss oder durch Kleben hergestellt werden.

### Kurze Beschreibung der Zeichnungen

Ausführungsbeispiele des erfindungsgemäßen Piezoaktors werden anhand der Zeichnungen erläutert. Es zeigen:
- Figur 1: einen Schnitt durch einen Piezoaktor mit einer Hülse und einer Membran nach dem Stand der Tech- nik,
- Figur 2: einen Schnitt durch einen mit einem ein- oder mehrlagigen Deckschichtsystem ummantelten erfin- dungsgemäßen Piezoaktor, der zwei hintereinander geschaltete Piezoelemente aufweist und
- Figur 3: einen Schnitt durch einen in Abwandlung zur Figur 2 nur teilweise mit einem ein- oder mehrlagigen Deckschichtsystem ummantelten Piezoaktor.

### Ausführungsformen der Erfindung

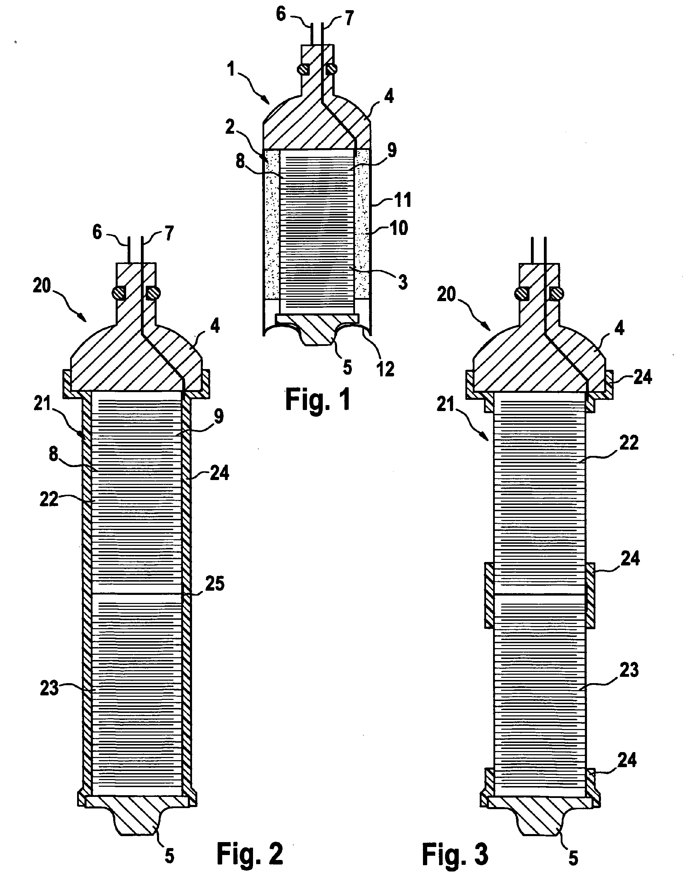

In Figur 1 ist eine herkömmliche an sich bekannte Anordnung 1 mit einem Piezoaktor 2 gezeigt, die beispielsweise zur Nadelhubsteuerung im Einspritzsystem für Kraftstoff bei einem Verbrennungsmotor eingesetzt werden kann. Ein Piezoelement 3 ist Bestandteil des Piezoaktors 2, der weiterhin noch einen Aktorfuß 4 und einen Aktorkopf 5, zum Beispiel aus Stahl, aufweist. Es sind elektrische Zuleitungen 6 und 7 durch den Aktorfuß 4 geführt, die über hier nicht näher dargestellte Außenelektroden an Innenelektroden 8 und 9 im Piezoelement 3 kontaktiert sind. Bei einer Betätigung des Piezoaktors 2 durch eine Spannungsbeaufschlagung der Innenelektroden 8 und 9 kann eine hier senkrecht unterhalb des Aktorkopfes 5 befindliche mechanische Anordnung derart betätigt werden, dass hier eine Freigabe einer Düsenöffnung des Einspritzsystems erfolgen kann.

Die Anordnung 1 mit dem Piezoaktor 2 ist in einem hier nicht gezeigten Injektorkörper eingebaut, wobei der Kraftstoff durch den Innenraum des Injektorkörpers an der Anordnung 1 vorgeigeführt wird. Dieser Kraftstoff kann dann beispielsweise bei einem sogenannten Common Rail System unter dem in der Beschreibungseinleitung erwähnten Raildruck oder einem anderen vorgebbaren Druck in den Brennraum eines hier nicht dargestellten Verbrennungsmotors injiziert werden.

Um den Piezoaktor 2 nach der Figur 1 vor dem umströmenden Kraftstoff und vor sonstigen schädlichen Einwirkungen zu schützen, ist eine Isolationsschicht 10 vorhanden, die wiederum mit einer Hülse 11 und einer Membran 12 verschlossen ist.

Aus Figur 2 ist eine erfindungsgemäße Anordnung 20 ersichtlich, bei der ein Piezoaktor 21 aus zwei Piezoelementen 22 und 23 gebildet ist, die in der Betätigungsrichtung in Reihe geschaltet sind. Die beiden Piezoelemente 22 und 23 sind an jeweils inaktiven Enden mit einem geeigneten Verfahren aneinander gefügt, wobei auch eine elektrische Verbindung 25 zur Verbindung der Außenelektroden hergestellt wird. Hier ist ein Deckschichtsystem 24 aus mindestens einer Lage eines Isolationsmaterials gebildet, das zumindest teilweise auch um den Aktorfuß 4 und den Aktorkopf 5 herumgeführt ist.

Bei einem Beispiel nach Figur 3 ist das Deckschichtsystem 24 nur an den Fügestellen zwischen den Piezoelementen 22 und 23 und an den Verbindungen der Piezoelemente 22 und 23 zum Aktorfuß 4 und zum Aktorkopf 5 angebracht.

Das erfindungsgemäße Deckschichtsystem 24 aus mehreren Lagen eines Isolationsmaterials kann dabei an die jeweiligen geometrischen Anforderungen einfach angepasst werden, um einen guten Schutz des Piezoaktors 21 in dem zur Verfügung stehenden Einbauraum im Haltekörper des zuvor erwähnten Piezoinjektors zu erreichen.

Das Deckschichtsystem 24 kann aus einem elastischen Material gebildet sein, das eine durch den Hub des Piezoaktors 21 verursachte Längsdehnung mitmacht. Andererseits kann auch auf eine Haftung auf der Oberfläche des Piezoaktors 21 verzichtet werden, so dass eine Relativbewegung der Lage des Deckschichtsystems 24 zur Oberfläche des jeweiligen Piezoelements 22 und/oder 23 und/oder der Lagen untereinander ausführbar ist.

## Patentansprüche

1. Piezoaktor (2;21), der mindestens ein Piezoelement (3,23) aufweist, das jeweils aus einem Mehrschichtaufbau von Piezolagen besteht, und mit einem Aktorkopf (5) und einem Aktorfuß (4) an den Enden des mindestens einen Piezoelements (3;22,23), wobei um das Piezoelement (22,23) oder bei in Betätigungsrichtung in Reihe liegenden Piezoelementen (22,23) um die Piezoelemente (22,23) und zumindest teilweise um den Aktorkopf (5) und den Aktorfuß (4) ein mehrlagiges Deckschichtsystem (24) aus mindestens einer Lage eines Isolationsmaterials, das den Piezoaktor vor schädlichen Einwirkungen schützt, angeordnet ist, wobei die mindestens eine Lage die Fügestellen zwischen dem oder den Piezoelementen (22,23) und dem Aktorkopf (5) und dem Aktorfuß (4) dichtend umschließt, wobei bei dem mehrlagigen Deckschichtsystem (24) nur teilweise mehrere Lagen vorhanden sind, wobei an jeder Stelle der Oberfläche des Piezoelements oder der Piezoelemente (22,23) und zumindest teilweise um den Aktorkopf (5) und den Aktorfuß (4) mindestens eine Lage des Isolationsmaterials vorhanden ist, **dadurch gekennzeichnet, dass** bei dem mehrlagigen Deckschichtsystem (24) zumindest die Lage direkt auf der Oberfläche des Piezoelements oder der Piezoelemente (22,23) nicht haftet, so dass eine Relativbewegung der Lage zur Oberfläche des jeweiligen Piezoelements (22,23) und/oder der Lagen untereinander ausführbar ist.

2. Piezoaktor nach Anspruch 1, **dadurch gekennzeichnet, dass** der Piezoaktor (21) aus mindestens zwei in Betätigungsrichtung in Reihe liegenden Piezoelementen (22,23) aufgebaut ist, die über inaktive Bereiche aneinander und an den Aktorkopf (5) und den Aktorfuß (4) gefügt sind.

3. Piezoaktor nach Anspruch 1 oder 2, **dadurch gekennzeichnet, dass** eine Verbindung zwischen der mindestens einen Lage des mehrlagigen Deckschichtsystems (24) und dem oder den Piezoelementen (22,23) sowie dem Aktorkopf (5) und dem Aktorfuß (4) zumindest teilweise durch Formschluss gebildet ist.

4. Piezoaktor nach Anspruch 1 oder 2, **dadurch gekennzeichnet, dass** eine Verbindung zwischen der mindestens einen Lage des mehrlagigen Deckschichtsystems (24) und dem Aktorkopf (5) und dem Aktorfuß (4) zumindest teilweise durch eine chemische Bindung gebildet ist.

5. Piezoaktor nach Anspruch 1 oder 2, **dadurch gekennzeichnet, dass** eine Verbindung zwischen der mindestens einen Lage des mehrlagigen Deckfschichtsystems (24) und dem Aktorkopf (5)und dem Aktorfuß (4) zumindest teilweise durch einen Haftvermittler gebildet ist.

6. Piezoaktor nach einem der vorhergehenden Ansprüche, **dadurch gekennzeichnet, dass** zumindest die Lage auf der Oberfläche des Piezoelements oder der Piezoelemente (22,23) aus elektrisch isolierendem Material gebildet ist.

7. Piezoaktor nach einem der vorhergehenden Ansprüche, **dadurch gekennzeichnet, dass** eine Verbindung zwischen den Piezoelementen (22,23) untereinander und/oder zwischen den Piezoelementen (22,23) und dem Aktorkopf (5) und/oder dem Aktorfuß (4) durch Formschluss, durch Kraftschluss oder durch Kleben gebildet ist.

8. Piezoaktor nach einem der vorhergehenden Ansprüche, **dadurch gekennzeichnet, dass** dieser Bestandteil eines Piezoinjektors für ein Einspritzsystem für Kraftstoff bei einem Verbrennungsmotor ist, wobei der Kraftstoff das Deckschichtsystem (24) umströmt.

## Claims

1. Piezo actuator (2; 21), which has at least one piezo element (3, 23), which in each case consists of a multiple-layer structure of piezo layers, and having an actuator head (5) and an actuator foot (4) at the ends of the at least one piezo element (3; 22, 23), wherein a multiple-layer coating system (24) of at least one layer of an insulating material which protects the piezo actuator from damaging effects is arranged around the piezo element (22, 23) or, in the case of piezo elements (22, 23) lying in series in the actuating direction, around the piezo elements (22, 23), and at least partially around the actuator head (5) and the actuator foot (4), wherein the at least one layer encloses in a sealing manner the joints between the piezo element or elements (22, 23) and the actuator head (5) and the actuator foot (4), wherein, in the case of the multiple-layer coating system (24), multiple layers are only partially present, wherein at least one layer of the insulating material is present at every point of the surface of the piezo element or piezo elements (22, 23) and at least partially around the actuator head (5) and the actuator foot (4), **characterized in that,** in the case of the multiple-layer coating system (24), at least the layer directly on the surface of the piezo element or piezo elements (22, 23) does not stick, so that a relative movement of the layer in relation to the surface of the respective piezo element (22, 23) and/or of the layers in relation to one another can be performed.

2. Piezo actuator according to Claim 1, **characterized in that** the piezo actuator (21) is made up of at least two piezo elements (22, 23) lying in series in the actuating direction, which are joined to one another and to the actuator head (5) and the actuator foot (4) by way of inactive regions.

3. Piezo actuator according to Claim 1 or 2, **characterized in that** a connection between the at least one layer of the multiple-layer coating system (24) and the piezo element or elements (22, 23) as well as the actuator head (5) and the actuator foot (4) is at least partially formed by a form fit.

4. Piezo actuator according to Claim 1 or 2, **characterized in that** a connection between the at least one layer of the multiple-layer coating system (24) and the actuator head (5) and the actuator foot (4) is at least partially formed by a chemical bond.

5. Piezo actuator according to Claim 1 or 2, **characterized in that** a connection between the at least one layer of the multiple-layer coating system (24) and the actuator head (5) and the actuator foot (4) is at least partially formed by an adhesion promoter.

6. Piezo actuator according to one of the preceding claims, **characterized in that** at least the layer on the surface of the piezo element or piezo elements (22, 23) is formed from electrically insulating material.

7. Piezo actuator according to one of the preceding claims, **characterized in that** a connection between the piezo elements (22, 23) themselves and/or between the piezo elements (22, 23) and the actuator head (5) and/or the actuator foot (4) is formed by a form fit, by a force closure or by adhesion.

8. Piezo actuator according to one of the preceding claims, **characterized in that** it is a component part of a piezo injector for a fuel injection system in an internal combustion engine, the fuel flowing around the coating system (24).

## Revendications

1. Piézoactionneur (2; 21) qui présente un ou plusieurs piézoéléments (3, 23) tous constitués d'une structure multicouches de couches piézoélectriques et une tête d'actionneur (5) et un pied d'actionneur (4) aux extrémités du ou des piézoéléments (3; 22, 23),
un système multicouches (24) de couches de recouvrement constitué d'au moins une couche d'un matériau isolant qui protège le piézoactionneur d'effets dommageables étant disposé autour du piézoélément (22, 23) ou, lorsque les piézoéléments (22, 23) sont situés en série dans la direction d'action, autour des piézoéléments (22, 23) et au moins autour d'une partie de la tête d'actionneur (5) et du pied d'actionneur (4),
la ou les couches enfermant de manière étanche les emplacements de jonction entre le ou les piézoéléments (22, 23), la tête d'actionneur (5) et le pied d'actionneur (4),
plusieurs couches n'étant prévues que sur une partie du système (24) de couches de recouvrement lorsque ce système est multicouches,
au moins une couche de matériau isolant étant prévue en chaque emplacement de la surface du piézoélément ou des piézoéléments (22, 23) et au moins autour d'une partie de la tête d'actionneur (5) et du pied d'actionneur (4),
**caractérisé en ce que**
lorsque le système (24) de couches de recouvrement est multicouches, au moins la couche placée directement sur la surface du piézoélément ou des piézoéléments (22, 23) n'est pas adhérente de manière à permettre un déplacement relatif de la couche par rapport à la surface du piézoélément (22, 23) concerné et/ou des couches entre elles.

2. Piézoactionneur selon la revendication 1, **caractérisé en ce que** le piézoactionneur (21) est constitué d'au moins deux piézoéléments (22, 23) situés en série dans la direction d'action, rejoints l'un à l'autre par des parties inactives ainsi que sur la tête d'actionneur (5) et le pied d'actionneur (4).

3. Piézoactionneur selon les revendications 1 ou 2, **caractérisé en ce qu'**une liaison au moins en partie en correspondance géométrique est prévue entre la ou les couches du système multicouches (24) de couches de recouvrement, le ou les piézoéléments (22, 23), la tête d'actionneur (5) et le pied d'actionneur (4).

4. Piézoactionneur selon les revendications 1 ou 2, **caractérisé en ce qu'**une liaison est formée au moins en partie par liaison chimique entre la ou les couches du système multicouches (24) de couches de recouvrement, la tête d'actionneur (5) et le pied d'actionneur (4).

5. Piézoactionneur selon les revendications 1 ou 2, **caractérisé en ce qu'**une liaison est formée au moins en partie par un agent de renforcement de l'adhérence entre la ou les couches du système multicouches (24) de couches de recouvrement, la tête d'actionneur (5) et le pied d'actionneur (4).

6. Piézoactionneur selon l'une des revendications précédentes, **caractérisé en ce qu'**au moins la couche située sur la surface du piézoélément ou des piézoéléments (22, 23) est formée d'un matériau électriquement isolant.

7. Piézoactionneur selon l'une des revendications précédentes, **caractérisé en ce qu'**une liaison par correspondance géométrique, par correspondance mécanique ou par collage est formée entre les piézoéléments (22, 23) et/ou entre les piézoéléments (22, 23), la tête d'actionneur (5) et/ou le pied d'actionneur (4).

8. Piézoactionneur selon l'une des revendications précédentes, **caractérisé en ce qu'**il fait partie d'un piézoinjecteur pour système d'injection de carburant dans un moteur à combustion interne, le carburant balayant le système (24) de couches de recouvrement.
